# EUROPÄISCHE PATENTSCHRIFT

(11) **EP 3 432 006 B1**
(45) Veröffentlichungstag und Bekanntmachung des Hinweises auf die Patenterteilung: **11.12.2024**
(21) Anmeldenummer: 18171375.1
(22) Anmeldetag: 09.05.2018
(51) Int. Cl.: G01R 15/20, H02M 7/00, H01L 23/055, H01L 23/36

(54) **ELEKTRONIKEINRICHTUNG MIT IN EINEN KÜHLKÖRPER INTEGRIERTEN STROMSENSOR**
ELECTRONICS DEVICE WITH CURRENT SENSOR INTEGRATED INTO A HEAT SINK
DISPOSITIF ÉLECTRONIQUE AVEC UN CAPTEUR DE COURANT INTÉGRÉ DANS UN RADIATEUR

(30) Priorität: 20.07.2017 DE 102017212434
(43) Veröffentlichungstag der Anmeldung: 23.01.2019
(73) Patentinhaber: AUDI AG, 85045 Ingolstadt (DE)
(72) Erfinder: Apelsmeier, Andreas, 85131 Pollenfeld (DE); Söhnle, Benjamin, 85051 Ingolstadt (DE); Brüske, Stephan, 24116 Kiel (DE)

(56) Entgegenhaltungen:
- EP-A1- 3 236 724
- EP-A2- 2 261 973
- WO-A1-94/27157
- DE-A1- 102015 111 204
- DE-A1- 102015 202 770
- US-A1- 2006 255 793
- US-A1- 2008 048 642

## Beschreibung

Die Erfindung betrifft eine Elektronikeinrichtung mit wenigstens einer zu kühlenden Komponente, einem Kühlelement zur Kühlung der zu kühlenden Komponente, wenigstens einer Stromleitung und einem jeweiligen Stromsensor zur Erfassung einer Stromstärke eines durch die jeweilige Stromleitung fließenden Stroms, wobei das Kühlelement eine Ausnehmung aufweist, in die der Stromsensor eingreift oder in der der Stromsensor angeordnet ist. Daneben betrifft die Erfindung ein Kraftfahrzeug.

In einer Vielzahl von Anwendungsfällen ist es erforderlich, einer Elektronikeinrichtung zugeführte Ströme bzw. durch diese bereitgestellte Ströme zu überwachen. Beispielsweise soll bei Traktionswechselrichtern in Kraftfahrzeugen typischerweise eine Überwachung und Regelung der bereitgestellten Leistung bzw. Stromstärke erfolgen. Hierzu können Wechselstromsensoren genutzt werden. Als Wechselstromsensoren können beispielsweise Hall-Sensoren genutzt werden. Um eine hohe Empfindlichkeit bei einer möglichst einfachen Beschaltung zu erreichen, können Open-Loop-Hall-Sensoren genutzt werden, die einen Flusskonzentrator, beispielsweise einen um die Leitung geführten Ring aus Weicheisen, aufweisen. Bei einer Open-Loop-Sensorik wird die Hall-Spannung direkt erfasst.

Problematisch ist hierbei, dass entsprechende Hall-Sensoren relativ großbauend sind. Zudem können sich die Komponenten des Hall-Sensors im Betrieb erwärmen, womit potentiell Messfehler auftreten können bzw. die Messgenauigkeit sinkt.

Aus der Druckschrift DE 10 2004 054 317 A1 ist eine Strommessvorrichtung bekannt, bei der der Strom durch einen Stromkanal fließt, der so angeordnet ist, dass er einen vorbestimmten Punkt auf einem Substrat umgibt. An diesem Punkt ist ein magnetisches Messelement zur Umwandlung des magnetischen Flusses in eine Spannung vorgesehen. Der Stromkanal ist in Schichten auf einem hochwärmeleitfähigen Substrat aufgetragen, an dessen Rückseite ein wärmeableitender Kühlkörper angeordnet ist. Nachteilig an diesem Vorgehen ist, dass weiterhin ein relativ großer Bauraum zur Strommessung erforderlich ist. Zudem ist es nicht möglich, Standardkomponenten zur Strommessung zu nutzen, woraus letztlich höhere Kosten und eine höhere Komplexität für die Elektronikeinrichtung resultieren.

Die Druckschrift DE 10 2015 111 204 A1 offenbart ein leistungselektronisches Modul mit Lastanschlusselementen. Hierbei weisen ein Schaltungsträger und eine Grundplatte Ausnehmungen auf, die zueinander fluchtend angeordnet sind, wobei ein Lastanschlusselement durch diese Ausnehmungen geführt ist. Die Grundplatte kann eine Kühleinrichtung sein. Ein Stromsensor kann teilweise oder vollständig in einer Erweiterung der Ausnehmung der Grundplatte angeordnet sein.

Die nachveröffentlichte Druckschrift EP 3 236 724 A1 offenbart eine leistungselektronische Anordnung. Ein Stromsensor ist in einer Ausnehmung einer Flüssigkeitskühleinrichtung angeordnet.

Die Druckschrift DE 10 2015 202 770 A1 betrifft eine Vorrichtung zur integrierten Strommessung innerhalb einer Hochvolt-Kontaktierung eines Hybridmoduls. Die Stromsensoren sind in ein Kunststoffgehäuse der Hochvolt-Kontaktierungssteckverbindung eingegossen. Ähnliche Anordnungen von Stromsensoren sind auch aus den Druckschriften US 2008/0048642 A1 und US 2006/0255793 A1 bekannt.

Aus der Druckschrift WO 94/27157 A1 ist eine Strommesseinrichtung bekannt, bei der die Joche verschiedener Strommesseinrichtungen in separaten Ausnehmungen eines Gehäuseteils aufgenommen sind.

Die Druckschrift EP 2 261 973 A2 beschreibt ein leistungselektronisches System mit einer Umhausung, einer Kühleinrichtung und einer Stromrichterschaltung.

Der Erfindung liegt somit die Aufgabe zugrunde, eine platzsparende Möglichkeit zur Messung einer Stromstärke in einer Elektronikeinrichtung anzugeben, die insbesondere mit geringer technischer Komplexität umsetzbar ist.

Die Aufgabe wird erfindungsgemäß durch eine Elektronikeinrichtung der eingangs genannten Art gelöst, wobei mehrere der Stromsensoren gemeinsam in der Ausnehmung des Kühlelements angeordnet sind.

Erfindungsgemäß wird somit vorgeschlagen, einen Stromsensor zumindest teilweise in ein ohnehin in der Elektronikeinrichtung vorgesehenes Kühlelement zu integrieren. Durch die zumindest teilweise Aufnahme des Stromsensors in dem Kühlelement kann Bauraum eingespart werden. Zugleich resultiert hieraus eine Kühlung des Stromsensors, wodurch potentiell die Baugröße des Stromsensors weiter reduziert werden kann und/oder seine Messempfindlichkeit steigen kann.

Das Kühlelement kann beispielsweise eine Kühlplatte sein, die dazu dienen kann, elektrische Halbleiterschalter oder andere wärmeerzeugende Komponenten der Elektronikeinrichtung zu kühlen. Die Kühlplatte kann beispielsweise eine Metallplatte sein, die aufgrund ihrer hohen Wärmeleitfähigkeit die Oberfläche zum Abstrahlen von Wärme vergrößert. Es ist jedoch auch möglich, dass das Kühlelement bzw. die Kühlplatte eine aktive Kühlung umfasst. Beispielsweise kann das Kühlelement bzw. die Kühlplatte von Kühlkanälen durchsetzt sein, die von einem Kühlfluid durchströmt werden.

Der Stromsensor kann als vorkonfektioniertes Modul ausgebildet sein, das, insbesondere über ein Gehäuse des Stromsensors, an der Kühlplatte befestigt ist. Der Stromsensor kann mit dem Kühlelement verschraubt, vernietet, verrastet oder verklebt sein. Der Stromsensor kann insbesondere ein Wechselstromsensor sein. Beispielsweise kann ein Hall-Sensor mit Flusskonzentrator genutzt werden. Der Stromsensor kann insbesondere eine Spannung bereitstellen, die von der gemessenen Stromstärke abhängt. Diese kann, insbesondere mithilfe eines Analog-Digital-Wandlers, durch eine Steuereinrichtung erfasst werden.

Die Elektronikeinrichtung kann ein Elektronikmodul sein, das wenigstens einen definierten Anschluss zur Verbindung mit weiteren Komponenten aufweist. Die Komponenten des Elektronikmoduls können insbesondere innerhalb eines Gehäuses angeordnet sein. Die Ausnehmung des Kühlelements kann insbesondere eine Durchbrechung sein.

Die Stromleitung kann zur Energieversorgung der Elektronikeinrichtung dienen oder über sie kann Energie von der Elektronikeinrichtung an eine andere Komponente bereitgestellt werden. Ist die Elektronikeinrichtung beispielsweise ein Stromwandler, kann der Strom einer oder mehrerer Ausgangsleitungen gemessen werden. Alternativ oder ergänzend ist es jedoch auch möglich, dass die Stromleitung mehrere Komponenten der Elektronikeinrichtung miteinander verbindet.

Vorzugsweise ist die Stromleitung durch eine Ausnehmung des Stromsensors geführt. Die Strommessung kann insbesondere kontaktlos sein. Die Ausnehmung kann zumindest abschnittsweise von einem Flusskonzentrator des Stromsensors umgeben sein, beispielsweise von einem offenen Weicheisenring. Die Ausnehmung kann insbesondere ein Gehäuse des Stromsensors durchsetzen. Die Stromleitung kann zumindest einseitig mit einem offenen Kontaktbereich enden, der zum Anschluss eines Verbindungsmittels dient. Beispielsweise kann die Stromleitung in einem Stecker oder einer Buchse enden.

Die Ausnehmung des Kühlelements kann eine Durchbrechung sein, durch die die Stromleitung hindurchgeführt ist. Insbesondere kann der Stromsensor in der Durchbrechung angeordnet sein und die Stromleitung kann durch den Stromsensor hindurchgeführt sein. Durch das Führen der Stromleitung durch die Durchbrechung kann eine Kühlung der Stromleitung, insbesondere im Bereich des Stromsensors, erreicht werden. Hierdurch kann es möglich sein, eine Stromleitung zu verwenden, die zumindest im Bereich des Stromsensors einen geringeren Leitungsquerschnitt aufweist als er bei einer ungekühlten Leitung erforderlich wäre. Bei einer Nutzung eines kleineren Leitungsquerschnitts kann jedoch zugleich ein Flusskonzentrator mit geringerem Innendurchmesser genutzt werden, wodurch insgesamt ein kleiner bauender Stromsensor realisiert werden kann.

Erfindungsgemäß sind mehrere Stromsensoren gemeinsam in der Ausnehmung des Kühlelements angeordnet. Die Stromsensoren können insbesondere in einem gemeinsamen Gehäuse angeordnet sein. Hierdurch kann die Elektronikeinrichtung einfacher aufgebaut werden. Werden mehrere Stromsensoren gemeinsam in einer Durchbrechung angeordnet, wobei die Stromleitungen jeweils durch die Stromsensoren geführt sind, kann insbesondere durch Kontaktbereiche der Stromleitungen an einer Seite des Kühlelements ein Verbindungselement, beispielsweise ein Stecker oder eine Buchse, für alle Stromleitungen ausgebildet werden. Hierdurch kann eine Verbindung mehrerer Stromleitungen einfach umgesetzt werden.

Ein Gehäuse, das einen oder mehrere Stromsensoren aufweist, kann derart geformt sein, dass es durch die Ausnehmung des Kühlelements geführt bzw. gehaltert wird. Ist die Ausnehmung eine Durchbrechung, so kann das Gehäuse einen Stützabschnitt aufweisen, der über die Durchbrechung hinausragt, so dass das Gehäuse nach dem Einsetzen in die Durchbrechung mit dem Stützabschnitt auf dem Kühlelement aufliegt. Hierdurch wird eine besonders einfache Montage des Stromsensors bzw. der Stromsensoren erreicht. Der Stützabschnitt kann eine Ausnehmung oder Durchbrechung aufweisen, um beispielsweise eine Schraube oder eine Niete zu führen, mit der der Stromsensor an dem Kühlelement befestigt ist.

Der Stromsensor kann ein die Stromleitung umgreifendes Flusskonzentrationselement aufweisen, das in Umfangsrichtung eine Öffnung aufweist, in der eine Hall-Sonde angeordnet ist. Das Flusskonzentrationselement kann beispielsweise eine offene Ringform bzw. eine C-Form aufweisen. Hall-Sonden mit Flusskonzentrator sind im Stand der Technik prinzipiell bekannt und sollen nicht detailliert erläutert werden. Bei einer Hall-Sonde wird, zumindest bei O-pen-Loop-Messungen, ein fester Strom an die Hall-Sonde angelegt und eine im Wesentlichen senkrecht hierzu abfallende Spannung gemessen. Da ein eindeutiger Zusammenhang zwischen dem induzierten Feld und einer geführten Stromstärke und einer an einer Hall-Sonde abfallenden Spannung und einem die Hall-Sonde durchsetzenden Feld vorliegt, kann somit eine Stromstärke in der Stromleitung kontaktlos gemessen werden. Der Zusammenhang zwischen einer an der Hall-Sonde abfallenden Spannung und der Stromstärke kann näherungsweise als linear angenommen werden. Es ist jedoch auch möglich, diesen Zusammenhang vorangehend zu messen und beispielsweise als Wertetabelle in einer die Messdaten der Hall-Sonde erfassenden Steuereinrichtung abzulegen.

Das Flusskonzentrationselement kann beispielsweise aus Weicheisen oder einem anderen paramagnetischen bzw. weichmagnetischen Material bestehen. Das Flusskonzentrationselement und/oder die Hall-Sonde können zumindest teilweise, vorzugsweise vollständig, innerhalb der Ausnehmung des Kühlelements liegen. Durch eine Kühlung der Hall-Sonde und/oder des Flusskonzentrationselements kann die Empfindlichkeit der Hall-Sonde verbessert werden und es kann insgesamt ein kleiner bauender Stromsensor realisiert werden.

Die Elektronikeinrichtung kann ein Stromrichter sein oder einen Stromrichter umfassen. Sie kann insbesondere ein Wechselrichter, insbesondere für einen elektrischen Motor, beispielsweise einen Antriebsmotor eines Kraftfahrzeugs, sein.

Die zu kühlende Komponente oder wenigstens eine der zu kühlenden Komponenten kann ein Halbleiterschalter sein. Der Halbleiterschalter kann ein Transistor, beispielsweise ein IGBT oder ein Mosfet, sein. Schaltungen zum Umrichten von Strömen mithilfe von Halbleiterschaltern sind im Stand der Technik bekannt und sollen daher nicht erläutert werden. Gegenüber beispielsweise Relais erlauben Halbleiterschalter deutlich kürzere Schaltintervalle. Mittlerweile können Halbleiterschalter realisiert werden, die bei einem geschlossenen Schalter einen sehr geringen Widerstand aufweisen. Dennoch fällt, insbesondere bei einer Richtung von Hochströmen, wie sie beispielsweise für Antriebsmotoren erforderlich sind, eine gewisse Verlustleistung am Halbleiterschalter ab, wodurch entsprechende Schaltungen typischerweise gekühlt werden. Ein hierfür notwendiges Kühlelement kann in der erfindungsgemäßen Elektronikeinrichtung gleichzeitig zur Aufnahme und zur Kühlung des Stromsensors genutzt werden.

Das Kühlelement kann zumindest im Bereich der Ausnehmung aus Metall bestehen. Ein Kühlelement aus Metall, insbesondere eine Kühlplatte, weist eine gute Wärmeleitfähigkeit auf und kann somit dazu dienen, eine Oberfläche, über die Wärme abgestrahlt werden kann, zu vergrößern. Wie bereits erläutert kann es vorteilhaft sein, zusätzlich eine aktive Kühlung vorzusehen, wobei beispielsweise Kühlfluid durch Kühlkanäle des Kühlelements geführt werden kann. Die zumindest bereichsweise Ausbildung des Kühlelements aus Metall verbessert die elektromagnetische Abschirmung des Stromsensors gegenüber externen Einflüssen. Dies kann dazu dienen, die Messgenauigkeit weiter zu erhöhen. Alternativ oder ergänzend kann aufgrund der verbesserten elektromagnetischen Abschirmung auch ein kleiner bauender Stromsensor realisiert werden.

Neben der erfindungsgemäßen Elektronikeinrichtung betrifft die Erfindung ein Kraftfahrzeug, das eine erfindungsgemäße Elektronikeinrichtung umfasst. Die Elektronikeinrichtung kann insbesondere als Wechselrichter für einen Motor des Kraftfahrzeugs, speziell einen Antriebsmotor des Kraftfahrzeugs, verwendet werden.

Vorzugsweise umfasst das Kraftfahrzeug eine Steuereinrichtung, durch die die dem Motor zugeführte Leistung geregelt wird, wobei wenigstens einer der Stromsensoren einen an den Motor bereitgestellten Strom erfasst, wobei ein Sensorsignal dieses Sensors als Eingangsgröße einer Leistungsregelung nutzbar ist. Die Regelung kann, beispielsweise durch eine Pulsweitensteuerung der bei der Wechselrichtung genutzten Halbleiterschaltern, den Strom auf einen Sollwert regeln.

Weitere Vorteile und Einzelheiten der Erfindung ergeben sich aus den folgenden Ausführungsbeispielen sowie den zugehörigen Zeichnungen. Hierbei zeigen schematisch:
- Fig. 1: ein Ausführungsbeispiel einer erfindungsgemäßen Elektronikeinrichtung,
- Fig. 2 und 3: Detailansichten eines weiteren Ausführungsbeispiels einer erfindungsgemäßen Elektronikeinrichtung, und
- Fig. 4: ein Ausführungsbeispiel eines erfindungsgemäßen Kraftfahrzeugs.

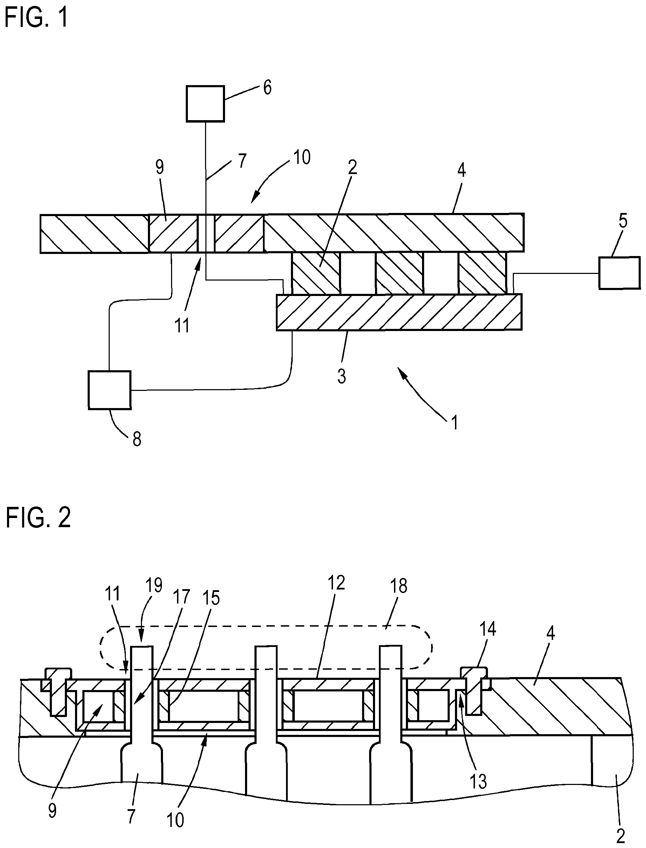

Fig. 1 zeigt eine Elektronikeinrichtung 1, mit mehreren zu kühlenden Komponenten 2, die auf einer Leiterplatine 3 angeordnet sind und durch eine Kühleinrichtung 4 gekühlt werden. Die Elektronikeinrichtung 1 ist im gezeigten Beispiel ein Wechselrichter, der einen durch eine Batterie 5 bereitgestellten Gleichstrom umrichtet und einen Wechselstrom an einen Motor 6 bereitstellt. Der Motor 6 kann beispielsweise ein Antriebsmotor eines Kraftfahrzeugs sein. Die Bereitstellung des Wechselstroms erfolgt über eine Stromleitung 7. Zur übersichtlicheren Darstellung ist in Fig. 1 nur eine Stromleitung 7 dargestellt. Wie später noch erläutert werden wird, können zur Bestromung des Motors 6 jedoch vorzugsweise mehrere Stromleitungen 7 verwendet werden, um einen Drehstrom an den Motor 6 bereitzustellen.

Die zu kühlenden Komponenten 2 können insbesondere Halbleiterschalter sein, die zur Umrichtung des Stroms genutzt werden. Hierzu können entsprechende Schaltsignale bzw. Pulsweiten und Phasenlagen durch eine Steuereinrichtung 8 vorgegeben werden. Das Kühlelement 4 kann eine Kühlplatte sein, die beispielsweise als Metallplatte ausgebildet sein kann. Optional könnten in dem Kühlelement 4 Kühlkanäle vorgesehen werden, durch die ein Kühlfluid geführt werden kann, um die Kühlung der zu kühlenden Komponente 2 weiter zu verbessern.

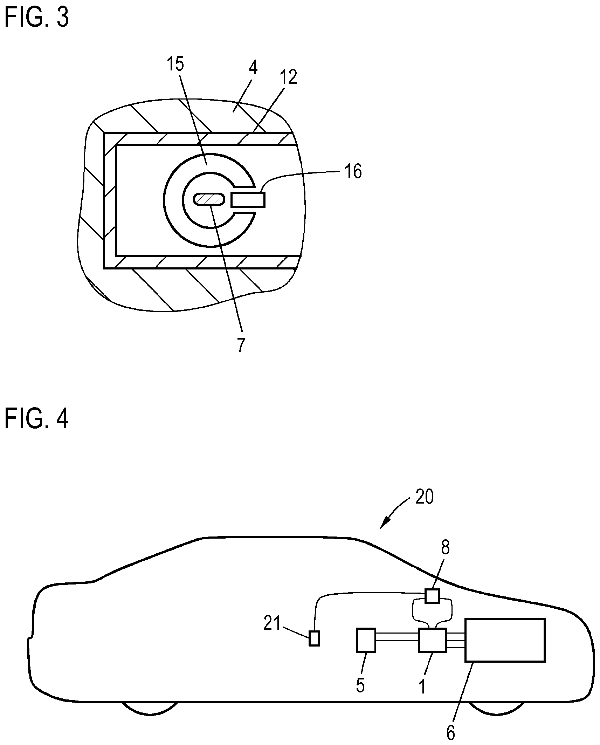

Um den über die Stromleitung 7 bereitgestellten Strom auf einen Sollwert zu regeln, soll durch die Steuereinrichtung 8 ein Ist-Wert des Stromes ermittelt werden. Hierzu weist die Elektronikeinrichtung 1 einen Stromsensor 9 auf, der in einer Ausnehmung 10, nämlich einer Durchbrechung, des Kühlelements 4 angeordnet ist. Der Aufbau des Stromsensors 9 wird später noch im Detail mit Bezug auf Fig. 2 und 3 erläutert werden. Der Stromsensor 9 wird durch einen Flusskonzentrator gebildet, der die Stromleitung 7 umgibt und der eine Durchbrechung aufweist, in der eine Hall-Sonde angeordnet ist. Wird mit einer solchen Hall-Sonde über zweite Kontakte ein fester Strom geführt, so kann über zwei weitere Kontakte eine Spannung abgegriffen werden, die näherungsweise proportional zum durch die Stromleitung 7 fließenden Strom ist. Nichtlinearitäten dieses Sensors können durch eine vorangehende Kalibrierung ausgeglichen werden, wozu in der Steuerung 8 beispielsweise eine Look-Up-Tabelle abgelegt sein kann.

Das Stromkabel 7 ist durch eine Ausnehmung 11, nämlich eine Durchbrechung, des Stromsensors 9 geführt, um eine kontaktlose Messung des Stroms zu ermöglichen.

Der gezeigte Aufbau der Elektronikeinrichtung 1 ermöglicht durch die Anordnung des Stromsensors 9 in der Kühleinrichtung 4 eine Integration einer Strommessung bei einem geringen Bauraumverbrauch. Da zudem sowohl der Stromsensor 9 als auch die Stromleitung 7 im Bereich des Stromsensors 9 durch das Kühlelement 4 mitgekühlt werden, kann die Messgenauigkeit des Stromsensors 9 verbessert werden und der Leitungsquerschnitt der Stromleitung 7 kann verringert werden, wodurch auch die Nutzung eines kompakteren Stromsensors 9 ermöglicht wird.

Fig. 2 und 3 zeigen Detailansichten eines weiteren Ausführungsbeispiels einer Elektronikeinrichtung. Der Aufbau entspricht im Wesentlichen der in Fig. 1 gezeigten Einrichtung, wobei statt einer Stromleitung 7 drei Stromleitungen 7 verwendet werden, um drei Phasen eines Wechselstroms an eine externe Einrichtung, beispielsweise den Motor6, bereitzustellen. Bereits mit Bezug zu Fig. 1 diskutierte Elemente werden hierbei mit den gleichen Bezugszeichen bezeichnet.

In der Ausnehmung 10 des Kühlelements 4 sind drei Stromsensoren 9 für die drei Stromleitungen 7 angeordnet. Diese sind über ein gemeinsames Gehäuse 12 an dem Kühlelement 4 befestigt. Das Gehäuse 12 kann in Fig. 2 von oben in die Ausnehmung 10 eingesetzt werden und liegt mit Stützabschnitten 13 auf dem Rand der Ausnehmung 10 auf. Diese weisen Durchbrechungen auf, um das Gehäuse 10 und somit die Stromsensoren 9 mit Befestigungselementen 14, beispielsweise mit Schrauben, an dem Kühlelement 4 zu befestigen.

Die einzelnen Stromsensoren 9 werden durch ein die Stromleitung 7 umgreifendes Flusskonzentrationselement 15 und eine Hall-Sonde 16 gebildet, wobei das Flusskonzentrationselement 15 in Umfangsrichtung eine Öffnung aufweist, in der die Hall-Sonde 16 angeordnet ist. Die Verdrahtung der Hall-Sonde 16 ist aus Übersichtlichkeitsgründen nicht dargestellt. Die Abschnitte 17 der Stromleitungen 7, in denen diese das Kühlelement 4 und den Stromsensor 9 durchqueren, weisen einen verengten Querschnitt auf. Dies wird dadurch ermöglicht, dass die Stromleitung 7 in diesem Bereich 17 jeweils durch das Kühlelement 4 gekühlt wird, wodurch die Stromtragefähigkeit verbessert wird. Dies ermöglicht es, dass auch die Ausnehmung 11 des Stromsensors 9 bzw. des Flusskonzentrationselements 15 einen kleineren Durchmesser aufweist, als er anderenfalls erforderlich wäre, womit der Stromsensor 9 insgesamt kompakter aufgebaut werden kann.

Die Stromleitungen 7 weisen einseitig offene Kontakte 19 auf, durch die ein Stecker 18 im Bereich des Kühlelements gebildet wird. An diesen kann über ein entsprechendes Verbindungselement beispielsweise der Motor 6 angeschlossen werden.

Ist das Kühlelement 4 zumindest im Bereich der Ausnehmung 10 aus Metall gebildet, so kann das Kühlelement 4 zugleich zur elektromagnetischen Abschirmung des Stromsensors 9 dienen, womit dessen Messgenauigkeit verbessert werden kann.

Fig. 4 zeigt ein Kraftfahrzeug 20, das als Motor 6 einen elektronischen Antriebsmotor aufweist, der durch die Batterie 5, beispielsweise eine Hochspannungsbatterie, gespeist wird. Um den durch die Batterie 5 bereitgestellten Gleichstrom in einen dreiphasigen Wechselstrom umzuwandeln, ist eine Elektronikeinrichtung 1 vorgesehen, die wie zu Fig. 1 erläutert, aufgebaut ist, wobei wie mit Bezug zu Fig. 2 und 3 erläutert wurde, separate Stromleitungen 7 für die einzelnen Phasen des Wechselstroms verwendet werden. Durch die Steuereinrichtung 8 werden Daten einer Vielzahl von Fahrzeugeinrichtungen 21, beispielsweise von einem Fahrpedalsensor, erfasst, um eine Sollleistung für den Motor 6 vorzugeben. Um diese Sollleistung einzustellen, erfasst die Steuereinrichtung 8 einerseits über die Stromsensoren 9 der Elektronikeinrichtung 1 die aktuell bereitgestellte Stromstärke und gibt andererseits Pulsweiten für die Halbleiterschalter der Elektronikeinrichtung vor, um die tatsächlich abgegebene Stromstärke auf die Sollstromstärke zu regeln.

## Patentansprüche

1. Elektronikeinrichtung mit wenigstens einer zu kühlenden Komponente (2), einem Kühlelement (4) zur Kühlung der zu kühlenden Komponente (2), wenigstens einer Stromleitung (7) und einem jeweiligen Stromsensor (9) zur Erfassung einer Stromstärke eines durch die jeweilige Stromleitung (7) fließenden Stroms, wobei das Kühlelement (4) eine Ausnehmung (10) aufweist, in die der Stromsensor (9) eingreift oder in der der Stromsensor (9) angeordnet ist,
**dadurch gekennzeichnet,**
**dass** mehrere der Stromsensoren (9) gemeinsam in der Ausnehmung (10) des Kühlelements (4) angeordnet sind.

2. Elektronikeinrichtung nach Anspruch 1,
**dadurch gekennzeichnet,**
**dass** die Stromleitung (7) durch eine Ausnehmung (11) des Stromsensors (9) geführt ist.

3. Elektronikeinrichtung nach Anspruch 1 oder 2,
**dadurch gekennzeichnet,**
**dass** die Ausnehmung (10) des Kühlelements (4) eine Durchbrechung ist, durch die die Stromleitung (7) hindurch geführt ist.

4. Elektronikeinrichtung nach einem der vorangehenden Ansprüche
**dadurch gekennzeichnet,**
**dass** die Stromsensoren (9) in einem gemeinsamen Gehäuse (12) angeordnet sind.

5. Elektronikeinrichtung nach einem der vorangehenden Ansprüche,
**dadurch gekennzeichnet,**
**dass** der Stromsensor (9) ein die Stromleitung (7) umgreifendes Flusskonzentrationselement (15) aufweist, das in Umfangsrichtung eine Öffnung aufweist, in der eine Hallsonde (16) angeordnet ist.

6. Elektronikeinrichtung nach einem der vorangehenden Ansprüche,
**dadurch gekennzeichnet,**
**dass** sie ein Stromrichter ist oder einen Stromrichter umfasst.

7. Elektronikeinrichtung nach Anspruch 6,
**dadurch gekennzeichnet,**
**dass** die zu kühlende Komponente (2) oder wenigstens eine der zu kühlenden Komponenten (2) ein Halbleiterschalter ist.

8. Elektronikeinrichtung nach einem der vorangehenden Ansprüche,
**dadurch gekennzeichnet,**
**dass** das Kühlelement (4) zumindest im Bereich der Ausnehmung (10) aus Metall besteht.

9. Kraftfahrzeug,
**dadurch gekennzeichnet,**
**dass** es eine Elektronikeinrichtung (1) nach einem der vorangehenden Ansprüche umfasst.

## Claims

1. Electronic apparatus with at least one component (2) to be cooled, a cooling element (4) for cooling the component (2) to be cooled, at least one power line (7) and a corresponding current sensor (9) for detecting a current intensity of a current flowing through the corresponding power line (7), wherein the cooling element (4) has a recess (10), in which the current sensor (9) engages or in which the current sensor (9) is arranged,
**characterised in that**
multiple of the current sensors (9) are arranged together in the recess (10) in the cooling element (4).

2. Electronic apparatus according to claim 1,
**characterised in that**
the power line (7) is guided through a recess (11) in the current sensor (9).

3. Electronic apparatus according to claim 1 or 2,
**characterised in that**
the recess (10) in the cooling element (4) is an opening though which the power line (7) is guided.

4. Electronic apparatus according to any one of the preceding claims
**characterised in that**
the current sensors (9) are arranged in a common housing (12).

5. Electronic apparatus according to any one of the preceding claims,
**characterised in that**
the current sensor (9) has a flow concentration element (15) surrounding the power line (7), which has an opening in the circumferential direction, in which a Hall probe (16) is arranged.

6. Electronic apparatus according to any one of the preceding claims,
**characterised in that**
it is a power converter or comprises a power converter.

7. Electronic apparatus according to claim 6,
**characterised in that**
the component (2) to be cooled or at least one of the components (2) to be cooled is a semiconductor switch.

8. Electronic apparatus according to any one of the preceding claims,
**characterised in that**
the cooling element (4) consists of metal, at least in the region of the recess (10).

9. Motor vehicle
**characterised in that**
it comprises an electronic apparatus (1) according to any one of the preceding claims.

## Revendications

1. Appareil électronique avec au moins un composant à refroidir (2), un élément de refroidissement (4) pour refroidir le composant à refroidir (2), au moins une ligne de courant (7) et un capteur de courant respectif (9) pour détecter une intensité de courant d'un courant circulant à travers la ligne de courant respective (7), dans lequel l'élément de refroidissement (4) présente un évidement (10) dans lequel le capteur de courant (9) s'engage ou dans lequel le capteur de courant (9) est disposé,
**caractérisé en ce que**
plusieurs des capteurs de courant (9) sont disposés ensemble dans l'évidement (10) de l'élément de refroidissement (4).

2. Appareil électronique selon la revendication 1,
**caractérisé en ce que**
la ligne de courant (7) est guidée à travers un évidement (11) du capteur de courant (9).

3. Appareil électronique selon la revendication 1 ou 2,
**caractérisé en ce que**
l'évidement (10) de l'élément de refroidissement (4) est une perforation à travers laquelle la ligne de courant (7) est guidée.

4. Appareil électronique selon l'une quelconque des revendications précédentes,
**caractérisé en ce que**
les capteurs de courant (9) sont disposés dans un boîtier commun (12).

5. Appareil électronique selon l'une quelconque des revendications précédentes,
**caractérisé en ce que**
le capteur de courant (9) présente un élément de concentration de flux (15) entourant la ligne de courant (7), qui présente une ouverture dans la direction circonférentielle, dans laquelle une sonde à effet Hall (16) est disposée.

6. Appareil électronique selon l'une quelconque des revendications précédentes,
**caractérisé en ce que**
il est un convertisseur ou comprend un convertisseur.

7. Appareil électronique selon la revendication 6,
**caractérisé en ce que**
le composant à refroidir (2) ou au moins un des composants à refroidir (2) est un commutateur à semi-conducteurs.

8. Appareil électronique selon l'une quelconque des revendications précédentes,
**caractérisé en ce que**
l'élément de refroidissement (4) est constitué de métal au moins au niveau de l'évidement (10).

9. Véhicule à moteur,
**caractérisé en ce que**
il comprend un appareil électronique (1) selon l'une quelconque des revendications précédentes.
